# EUROPEAN PATENT APPLICATION

(11) **EP 4 371 770 A1**
(43) Date of publication of application: **22.05.2024**
(21) Application number: 22842023.8
(22) Date of filing: 06.07.2022
(51) Int. Cl.: B32B 27/32, B32B 7/027, B32B 9/00, C08J 7/043, C08J 7/048

(54) **LAMINATED FILM FOR FORMING INORGANIC THIN FILM LAYER**

(30) Priority: 15.07.2021 JP 2021117277
(71) Applicant: TOYOBO CO., LTD., Osaka-shi, Osaka 530-0001 (JP)
(72) Inventor: KASHIWA, Mitsuhiro, Inuyama-shi, Aichi 484-8508 (JP); YAMAZAKI, Atsushi, Inuyama-shi, Aichi 484-8508 (JP); NAKANO, Mahiro, Inuyama-shi, Aichi 484-8508 (JP)
(74) Representative: Vossius & Partner Patentanwälte Rechtsanwälte mbB
(86) International application number: PCT/JP2022/026881
(87) International publication number: WO 2023/286679

(57) **Abstract**

It is an object of the present invention to provide a laminated film that can form a laminated structure mainly composed of a polypropylene film and composed of substantially a single resin species having a low environmental load, and has gas barrier properties required for a packaging material when an inorganic thin film layer is laminated. A laminated film for forming an inorganic thin film layer, including: a substrate layer mainly composed of a polypropylene-based resin; and a coating layer laminated on at least one surface of the substrate layer, wherein the laminated film satisfies the following requirements (I) to (III). (I) the laminated film has a heating elongation rate at 130°C of 10% or less in both MD and TD directions. (II) a total of a maximum peak height (Rp) and maximum valley depth (Rv) of the coating layer-side surface measured with a scanning probe microscope is 30.0 nm or less. (III) an amount of adhesion of the coating layer is 0.10 g/m² or more and 0.50 g/m² or less.

## Description

### TECHNICAL FIELD

The present invention relates to a laminated film used in the packaging field of food products, pharmaceutical products, industrial products, and the like. Specifically, the present invention relates to a laminated film that can exhibit excellent gas barrier performance when a gas barrier laminated film including an inorganic thin film layer is formed using a material that is easily recycled.

In recent years, regulations for reducing the use of disposable plastics have been strengthened in various countries including Europe. Against this background, there is growing international awareness of resource circulation and growing waste problems in emerging countries. Therefore, for plastic packaging materials required for foods and pharmaceuticals and the like, environmentally friendly products are required from the viewpoint of 3R (recycle, reuse, reduce).

Examples of performance required for the above-described environmentally friendly packaging material include (1) including a material that is easily recycled, (2) having gas barrier performance capable of blocking various gases and extending the best-before expiration, and (3) having a laminated structure with a less environmental load (for example, the amount of materials used itself is small, and recycling by monomaterialization is possible).

In recent years, use of a polypropylene film has attracted attention in order to enable the above (1) and (3). The polypropylene film is generally used in a wide range of applications such as packaging of foods and various products, electrical insulation, and surface protection films. The polypropylene film can exhibit high water vapor barrier properties from its molecular structure. Furthermore, as a sealant to be bonded to a surface substrate film, a polypropylene-based or polyethylene-based heat-sealing resin is generally used, and therefore for example, by using a polypropylene film for a surface substrate and an un-stretched polypropylene sheet for the sealant, it is possible to achieve the monomaterialization of the entire packaging material while having gas barrier properties, and it is possible to design a packaging material which is environmentally friendly such as being easily recycled.

However, regarding the gas barrier properties of (2), the polypropylene film has water vapor barrier properties, but does not have a sufficient value as compared with, for example, a transparent inorganic vapor-deposited polyester film generally considered to have excellent water vapor barrier properties, and disadvantageously has very poor oxygen barrier properties.

Meanwhile, a gas barrier laminated body in which a metal thin film made of aluminum or the like or an inorganic thin film made of an inorganic oxide such as silicon oxide or aluminum oxide is formed on the surface of a plastic substrate film such as a polyester film is generally used. Among them, a gas barrier laminated body including a thin film of an inorganic oxide such as silicon oxide, aluminum oxide, or a mixture thereof is widely used because it is not necessary to use an aluminum foil, the gas barrier laminated body is transparent so that the contents can be confirmed, and the formed film is also very thin and does not inhibit recyclability.

Also in a polypropylene film, a method in which gas barrier properties can be imparted by laminating an inorganic thin film is disclosed (for example, Patent Document 1). However, the surface of the polypropylene film has large unevenness due to its molecular structure, and the inorganic thin film layer has many cracks, so that there is a problem that sufficient gas barrier properties cannot be exhibited.

In order to solve these problems, a method has been disclosed in which a polymer resin composition of polyvinyl alcohol is used between a polypropylene film and an inorganic thin film layer to smooth the surface on which the inorganic thin film layer is formed, thereby imparting gas barrier properties (for example, Patent Document 2). However, when a polymer resin composition of polyvinyl alcohol is used, the humidity dependency is large, and therefore the oxygen barrier property is lowered under high humidity, and the water vapor barrier property is not sufficient. In order to exhibit sufficient gas barrier performance, it was necessary to laminate the composition in a mass of at least 0.5 g/m² or more. When the adhesion amount is increased, impurities may occur at the time of recycling, and therefore recycling itself may become difficult. This is not suitable from the viewpoint of monomaterialization using a single material. Furthermore, there is a problem that the manufacturing cost is increased by increasing the adhesion amount.

### PRIOR ART DOCUMENT

### PATENT DOCUMENTS

Patent Document 1: WO2017/221781
Patent Document 2: JP-A-2021-20392

### SUMMARY OF THE INVENTION

### PROBLEMS TO BE SOLVED BY THE INVENTION

In Patent Document 1, the barrier performance is insufficient. In Patent Document 2, the gas barrier performance under high humidity is insufficient, and it is necessary to increase the film thickness in order to exhibit the effect. The workability improvement provided by thinning the coating layer and the consideration of the environment and manufacturing cost are not made. In other words, conventionally, there has been no material satisfying all of the following three points as the performances required for the above-mentioned environmentally friendly packaging material: (1) containing a recyclable material as a constituent material; (2) having gas barrier performance capable of blocking various gases and extending the best-before expiration; and (3) forming a laminated structure that is likely to be recycled and has a low environmental load (monomaterialization).

The present invention has been made in view of the problems of the prior art.

That is, an object of the present invention is to provide a laminated film which can form a laminated structure mainly composed of a polypropylene film and composed of substantially a single resin species having a low environmental load, and has gas barrier properties required for a packaging material when an inorganic thin film layer is laminated.

### MEANS FOR SOLVING THE PROBLEMS

The present inventors have found that a film exhibiting good gas barrier properties when an inorganic thin film layer is laminated can be provided by designing a predetermined laminated film suitable for required performance, and have completed the present invention.

That is, the present invention comprises the following constitutions.
1. A laminated film for forming an inorganic thin film layer, comprising: a substrate layer mainly composed of a polypropylene-based resin; and a coating layer laminated on at least one surface of the substrate layer,
   wherein the laminated film satisfies the following requirements (I) to (III):
   (I) the laminated film has a heating elongation rate at 130°C of 10% or less in both MD and TD directions;
   (II) a total of a maximum peak height (Rp) and maximum valley depth (Rv) of the coating layer-side surface measured with a scanning probe microscope is 30.0 nm or less; and
   (III) an amount of adhesion of the coating layer is 0.10 g/m² or more and 0.50 g/m² or less.
2. The laminated film for forming an inorganic thin film layer according to 1., wherein the laminated film has a heating elongation rate at 100°C of 3% or less in both MD and TD directions.
3. The laminated film for forming an inorganic thin film layer according to 1. or 2., wherein in a total reflection infrared absorption spectrum measured from a coating layer side of the laminated film, a ratio (P2/P1) of a peak intensity (P1) having an absorption maximum in a domain of 1720±10 cm⁻¹ to a peak intensity (P2) having an absorption maximum in a domain of 1070±10 cm⁻¹ is within a range of 0.1 or more and 30.0 or less.
4. A laminated film comprising an inorganic thin film layer laminated on the coating layer of the laminated film according to any one of 1. to 3..
5. The laminated film according to 4., wherein the inorganic thin film layer contains Al and/or Si.

### EFFECT OF THE INVENTION

By such a technique, the present inventors can provide a laminated film having barrier properties required for a packaging material when an inorganic thin film layer is laminated in consideration of the environment.

### MODE FOR CARRYING OUT THE INVENTION

Hereinafter, the present invention will be described in detail.

A laminated film for forming an inorganic thin film layer, comprising: a substrate layer mainly composed of a polypropylene-based resin; and a coating layer laminated on at least one surface of the substrate layer,
wherein the laminated film satisfies the following requirements (I) to (III):
(I) the laminated film has a heating elongation rate at 130°C of 10% or less in both MD and TD directions;
(II) a total of a maximum peak height (Rp) and maximum valley depth (Rv) of the coating layer-side surface measured with a scanning probe microscope is 30.0 nm or less; and
(III) an amount of adhesion of the coating layer is 0.10 g/m² or more and 0.50 g/m² or less.

Hereinafter, each layer of the laminated film will be explained.

### [Substrate film layer]

A propylene-based resin stretched film to be used as a substrate film in the present invention is preferably a biaxially stretched film. As the biaxially stretched polypropylene-based resin film, known biaxially stretched polypropylene-based resin films can be used, and raw materials and mixing ratios and the like thereof are not particularly limited. For example, the film may be made of a polypropylene homopolymer (propylene homopolymer), a random copolymer or a block copolymer containing propylene as a **main component and one or two or more selected from α-**olefins such as ethylene, butene, pentene, and hexene, or a mixture of two or more of these polymers. For the purpose of modifying the physical properties thereof, known additives such as an antioxidant, an anti-static agent, and a plasticizer may be added, and for example, a petroleum resin and a terpene resin and the like may be added.

The biaxially stretched polypropylene-based resin film used in the present invention may be a single-layer film, or may be a laminated film in which a plurality of resin films including the biaxially stretched polypropylene-based resin film are laminated. The kind, lamination number, and lamination method and the like of a laminated body in the case of forming the laminated film are not particularly limited, and can be optionally selected from known methods depending on the object.

In the present invention, a polypropylene resin constituting the substrate film is preferably a propylene homopolymer that does not substantially contain a comonomer, and even when the comonomer is contained, the amount of the comonomer is preferably 0.5 mol% or less. The upper limit of the amount of the comonomer is more preferably 0.3 mol%, and still more preferably 0.1 mol%. Within the above range, the crystallinity is improved, the dimensional change at a high temperature is reduced, that is, the elongation rate (hereinafter, heating elongation rate) when heated to a certain temperature is reduced, and the heat resistance is improved. A small amount of the comonomer may be contained as long as the crystallinity is not significantly lowered.

The polypropylene resin constituting the substrate film preferably contains a propylene homopolymer obtained only from a propylene monomer, and it is most preferable that the propylene homopolymer does not contain a heterologous bond such as a head-to-head bond.

The lower limit of a xylene-soluble content of the polypropylene resin constituting the substrate film is preferably 0.1% by mass from a practical viewpoint. The upper limit of the xylene-soluble content is preferably 7% by mass, more preferably 6% by mass, and still more preferably 5% by mass. Within the above ranges, crystallinity is improved, a heating elongation rate is further reduced, and heat resistance is improved.

In the present invention, the lower limit of the melt flow rate (MFR) (230°C, 2.16 kgf) of the polypropylene resin is preferably 0.5 g/10 min. The lower limit of the MFR is more preferably 1.0 g/10 min, still more preferably 2.0 g/10 min, particularly preferably 4.0 g/10 min, and most preferably 6.0 g/10 min. Within the above ranges, a mechanical load is small, facilitating extrusion and stretching. The upper limit of the MFR is preferably 20 g/10 min. The upper limit of the MFR is more preferably 17 g/10 min, still more preferably 16 g/10 min, and particularly preferably 15 g/10 min. Within the above ranges, stretching is facilitated, thickness unevenness is reduced, a stretching temperature and a heat setting temperature are likely to be increased, a heating elongation rate is further reduced, and heat resistance is improved.

From the viewpoint of heat resistance, the substrate film may be a uniaxially stretched film in a machine direction (MD direction) or a transverse direction (TD direction), but is preferably a biaxially stretched film. In the present invention, at least uniaxial stretching makes it possible to obtain a film having high heat resistance with a low heat shrinkage rate at a high temperature that cannot be expected with a conventional polypropylene film. Examples of a stretching method include a simultaneous biaxial stretching method and a sequential biaxial stretching method, and the sequential biaxial stretching method is preferable from the viewpoint of achieving satisfactory planarity, dimensional stability, and thickness nonuniformity and the like.

In the sequential biaxial stretching method, a polypropylene resin is heated and melted with a uniaxial or biaxial extruder so as to have a resin temperature of 200°C or higher and 280°C or lower. The melted product is formed in a sheet shape from a T-die, and extruded onto a chill roll having a temperature of 10°C or higher and 100°C or lower to obtain an un-stretched sheet. Subsequently, the un-stretched sheet can be roll-stretched at a stretching ratio of 3.0 or more and 8.0 or less in the machine direction (MD direction) at a temperature of 120°C or higher and 165°C or lower, preheated with a tenter, and then stretched at a stretching ratio of 4.0 or more and 20.0 or less in the transverse direction (TD direction) at a temperature of 155°C or higher and 175°C or lower. Furthermore, after biaxial stretching, a heat setting treatment can be performed while relaxation of 1% or more and 15% or less is allowed at a temperature of 165°C or higher and 175°C or lower.

In order to impart handleability (for example, winding properties after lamination) to the substrate film to be used in the present invention, it is preferable that particles are contained in the film to form protrusions on the surface of the film. Examples of the particles to be contained in the film include inorganic particles such as silica, kaolinite, talc, calcium carbonate, zeolite, and alumina particles, and heat-resistant polymer particles such as acrylic, PMMA, nylon, polystyrene, polyester, and benzoguanamine-formalin condensate particles. From the viewpoint of transparency, the content of the particles in the film is preferably small, and for example, is preferably 1 ppm or more and 1000 ppm or less. The average **particle size of the particles is preferably 1.0 to 3.0 µm, and more preferably 1.0 to 2.7 µm. The measurement method** of the average particle diameter as used herein is a method in which a photograph is taken with a scanning electron microscope, Feret's diameters in a horizontal direction are measured using an image analyzer device, and an average value thereof is displayed. Furthermore, it is preferable to select particles having a refractive index close to that of a resin to be used from the viewpoint of transparency. In order to impart various functions to the film as necessary, an antioxidant, an ultraviolet absorber, an anti-static agent, a dye, a lubricant, a nucleating agent, a pressure-sensitive adhesive, an antifogging agent, a flame retardant, an anti-blocking agent, and an inorganic or organic filler and the like may be contained.

Resins other than the polypropylene resin to be used in the present invention may be contained in the film as long as the object of the present invention is not impaired for the purpose of, for example, improving the mechanical properties of the substrate film and the adhesiveness of the gas barrier coat layer to an ink layer or an adhesive layer to be laminated on the gas barrier coat layer. Examples thereof include polypropylene resins different from those described above, random copolymers which are **copolymers of propylene and ethylene and/or an α**-olefin having 4 or more carbon atoms, and various elastomers.

In the present invention, the thickness of the substrate film is optionally set according to applications, **but the lower limit of the thickness is preferably 2 µm or more, more preferably 3 µm or more, and still more preferably 4 µm or more. Meanwhile,** the upper limit of the **thickness is preferably 300 µm or less, more preferably 250 µm or less, still more preferably 200 µm or less, and particularly preferably 100 µm or less. When the thickness** is small, the handleability of the substrate film is apt to be poor. Meanwhile, when the thickness is large, not only the substrate film causes a problem in terms of cost, but also poor planarity due to curling tendency is apt to occur when the substrate film is wound into a roll and preserved.

The haze of the polypropylene film to be used as the substrate of the present invention preferably has transparency from the viewpoint of the visibility of contents, and is specifically preferably 6% or less, more preferably 5% or less, and still more preferably 4% or less. The haze tends to be deteriorated, for example, when the stretching temperature and the heat setting temperature are too high, when a cooling roll (CR) temperature is high and the cooling rate of a stretched original fabric sheet is slow, and when a low molecular weight is too large, and therefore by adjusting these, the haze can be controlled within the above ranges.

The substrate film layer in the present invention may be subjected to a corona discharge treatment, a glow discharge treatment, a flame treatment, or a surface roughening treatment, or may be subjected to a known anchor coating treatment, printing, or decoration or the like as long as the object of the present invention is not impaired.

### [Coating layer]

In the present invention, a coating layer is provided in order to develop sufficient gas barrier properties when the inorganic thin film layer is laminated. By providing the coating layer, it is possible to suppress the appearance of the oligomer and the antiblocking materials from the polypropylene resin. Furthermore, when other layer is laminated on the coating layer, the adhesive force between layers can also be enhanced. In particular, in the formation of the inorganic thin film layer, a thin film cannot be formed not only due to an adhesive force but also as a result of a protruding portion produced by surface unevenness, and therefore there is also a problem that gas barrier properties or the like become poor. In addition, by using a material having gas barrier properties for the coating layer itself, the gas barrier performance of the laminated film can also be greatly improved. Furthermore, the coating layer prevents the entry of hot water into the substrate, and as a result, the whitening of the film after boiling or retorting can also be reduced.

In the present invention, the amount of adhesion of the coating layer is preferably 0.10 to 0.50 g/m². This makes it possible to uniformly control the coating layer in coating, resulting in a film with less coating uniformity and defects. Furthermore, the coating layer contributes to the suppression of the appearance of oligomers, and therefore haze after retorting is stabilized. The amount of adhesion of the coating layer is preferably 0.15 g/m² or more, more preferably 0.20 g/m² or more, and still more preferably 0.35 g/m² or more, and preferably 0.50 g/m² or less, more preferably less than 0.50 g/m², and further preferably 0.45 g/m² or less. When the amount of adhesion of the coating layer is more than 0.50 g/m², the gas barrier properties are improved, but a cohesive force in the coating layer is insufficient, and the uniformity of the coating layer is also deteriorated, and therefore uniformity and defects may occur in the coating appearance. In terms of workability, a large film thickness may cause blocking to occur, or increase manufacturing cost. Furthermore, there is a concern that the recyclability of the film is adversely affected. Meanwhile, when the film thickness of the coating layer is less than 0.10 g/m², sufficient gas barrier properties and adhesion between layers may not be obtained.

Examples of the resin composition used for the coating layer of the present invention include urethane-based, polyester-based, acryl-based, titanium-based, isocyanate-based, imine-based, and polybutadiene-based resins to which an epoxy-based, isocyanate-based, melamine-based or other curing agent is added. Furthermore, a crosslinking agent such as a silicon-based crosslinking agent, an oxazoline compound, a carbodiimide compound, or an epoxy compound can be contained.

In particular, the urethane resin is preferably contained because, in addition to the barrier performance due to the high cohesiveness of the urethane bond itself, a polar group interacts with the inorganic thin film layer and has flexibility due to the presence of an amorphous portion, and therefore damage can be suppressed even when a bending load is applied. A polyester resin is also suitable because the same effect can be expected. In the present invention, it is preferable to contain polyurethane containing polyester and isocyanate as a constituent component, and it is more preferable to add a silicon-based crosslinking agent from the viewpoint that the adhesiveness can be improved.

### (1) Urethane resin

For a urethane resin used in the present invention, it is more preferred from the viewpoint of the gas barrier performance thereof to use a urethane resin containing, as a main constituent component, an aromatic or aromatic-aliphatic diisocyanate component. It is particularly preferred that the urethane resin contains, out of such diisocyanate components, a m-xylylene diisocyanate component. The use of this resin allows that an effect of stacking between its aromatic rings heightens the cohesive force of the urethane bonds further, resulting in good gas barrier performance.

In the present invention, the proportion of the aromatic or aromatic-aliphatic diisocyanate(s) in the urethane resin is preferably set, in 100% by mole of the polyisocyanate component, to 50% or more by mole (50 to 100% by mole). The total proportion of the aromatic or aromatic-aliphatic diisocyanate(s) is preferably from 60 to 100% by mole, more preferably from 70 to 100% by mole, even more preferably from 80 to 100% by mole. When the total proportion of the aromatic or aromatic-aliphatic diisocyanate(s) is less than 50% by mole, the laminated film may not gain a good gas barrier performance.

### (2) Crosslinking agent

Various crosslinking agents may be blended in the urethane resin used in the present invention as long as the gas barrier properties are not impaired for the purpose of improving the cohesive force and wet heat resistance adhesiveness of the film. Examples of the crosslinking agent include a silicon-based crosslinking agent, an oxazoline compound, a carbodiimide compound, and an epoxy compound. Among them, the silicon-based crosslinking agent is particularly preferable from the viewpoint that water-resistant adhesiveness to the inorganic thin film layer can be particularly improved by blending the silicon-based crosslinking agent. In addition, an oxazoline compound, a carbodiimide compound, or an epoxy compound or the like may be used in combination as the crosslinking agent.

As the silicon-based crosslinking agent, a silane coupling agent is preferable from the viewpoint of crosslinking between an inorganic substance and an organic substance. Examples of the silane coupling agent include hydrolyzable alkoxysilane compounds such as halogen-containing alkoxysilanes (2-chloroethyltrimethoxysilane, 2-chloroethyltriethoxysilane, 3-chloropropyltrimethoxysilane, 3-chloropropyltriethoxysilane, and other chloroC2-4alkyltriC1-4alkoxysilanes), alkoxysilanes having an epoxy group [2-glycidyloxyethyltrimethoxysilane, 2-glycidyloxyethyltriethoxysilane, 3-glycidyloxypropyltrimethoxysilane, 3-glycidyloxypropyltriethoxysilane, and other glycidyloxyC2-4alkyltriC1-4alkoxysilanes, 3-glycidyloxypropylmethyldimethoxysilane, 3-glycidyloxypropylmethyldiethoxysilane, and other glycidyloxydiC2-4alkyldiC1-4alkoxysilanes, 2-(3,4-epoxycyclohexyl)ethyltrimethoxysilane, 2-(3,4-epoxycyclohexyl)ethyltriethoxysilane, 3-(3,4-epoxycyclohexyl)propyltrimethoxysilane, and other (epoxycycloalkyl)C2-4alkyltriC1-4alkoxysilanes], alkoxysilanes having an amino group [2-aminoethyltrimethoxysilane, 3-aminopropyltrimethoxysilane, 3-aminopropyltriethoxysilane, and other aminoC2-4alkyltriC1-4alkoxysilanes, 3-aminopropylmethyldimethoxysilane, 3-aminopropylmethyldiethoxysilane, and other aminodiC2-4alkyldiC1-4alkoxysilanes, 2-[N-(2-aminoethyl)amino]ethyltrimethoxysilane, 3-[N-(2-aminoethyl)amino]propyltrimethoxysilane, 3-[N-(2-aminoethyl)amino]propyltriethoxysilane, and other (2-aminoC2-4alkyl)aminoC2-4alkyltriC1-4alkoxysilanes, 3-[N-(2-aminoethyl)amino]propylmethyldimethoxysilane, 3-[N-(2-aminoethyl)amino]propylmethyldiethoxysilane, and other (aminoC2-4alkyl)aminodiC2-4alkyldiC1-4alkoxysilanes], alkoxysilanes having a mercapto group (2-mercaptoethyltrimethoxysilane, 3-mercaptopropyltrimethoxysilane, 3-mercaptopropyltriethoxysilane, and other mercaptoC2-4alkyltriC1-4alkoxysilanes, 3-mercaptopropylmethyldimethoxysilane, 3-mercaptopropylmethyldiethoxysilane, and other mercaptodiC2-4alkyldiC1-4alkoxysilanes), alkoxysilanes having a vinyl group (vinyltrimethoxysilane, vinyltriethoxysilane, and other vinyltriC1-4alkoxysilanes), and alkoxysilanes having an ethylenic unsaturated bond group [2-(meth)acryloxyethyltrimethoxysilane, 2-(meth)acryloxyethyltriethoxysilane, 3-(meth)acryloxypropyltrimethoxysilane, 3-(meth)acryloxypropyltriethoxysilane, and other (meth)acryloxyC2-4alkyltriC1-4alkoxysilanes, 3-(meth)acryloxypropylmethyldimethoxysilane, 3-(meth)acryloxypropylmethyldiethoxysilane, and other (meth)acryloxydiC2-4alkyldiC1-4alkoxysilanes). These silane coupling agents may be used alone or in combination of two or more thereof. Among them, silane coupling agent having an amino group is preferable.

The amount of the silicon-based crosslinking agent added into the coating layer is preferably 0.05 to 4.00 % by mass, more preferably 0.10 to 3.50 % by mass, and still more preferably 0.15 to 3.00% by mass. By the addition of the silane coupling agent, the curing of the film proceeds to improve the cohesive force, and as a result, a film having excellent water-resistant adhesiveness is obtained, and an effect of preventing the appearance of oligomers can also be expected. When the addition amount is more than 3.00% by mass, the curing of the film proceeds to improve the cohesive force, but an unreacted portion may also partially occur, resulting in deterioration in adhesiveness between layers. Meanwhile, when the addition amount is less than 0.05% by mass, a sufficient cohesive force may not be obtained.

### (3) Polyester resin

The polyester resin used in the present invention is produced by polycondensation of a polycarboxylic acid component and a polyhydric alcohol component. The molecular weight of the polyester is not particularly limited as long as the polyester can impart sufficient film toughness, coating suitability, and solvent solubility as a coating material, but is 1000 to 50000 in terms of a number average molecular weight, and more preferably 1500 to 30000. A functional group having a polyester terminal is not particularly limited, and may have an alcohol terminal, a carboxylic acid terminal, or both the terminals. However, when an isocyanate-based curing agent is used in combination, it is necessary to use a polyester polyol mainly composed of an alcohol terminal.

The Tg of the polyester used in the present invention is preferably 10°C or higher. This is because when the temperature is lower than 10°C, the resin has adhesion after coating operation, blocking easily occurs, and winding operation after coating is difficult. This is because when the Tg is 10°C or lower, it is difficult to take measures for preventing blocking even under a situation where pressure near a winding core is high due to the addition of an antiblocking agent. The Tg is more preferably 15°C or higher, and still more preferably 20°C or higher.

The polyester used in the present invention is obtained by polycondensation of a polyvalent carboxylic acid component and a polyhydric alcohol component.

### [Polyvalent carboxylic acid component]

The polyvalent carboxylic acid component of the polyester used in the present invention contains at least one of ortho-oriented aromatic dicarboxylic acid or an anhydride thereof. When the ortho orientation makes it possible to improve solubility in a solvent to uniformly coat the substrate. The uniformly coated coating layer has a small variation in barrier performance, and consequently contributes to the suppression of oligo-whitening. The ortho orientation provides a film having excellent flexibility and an improved interfacial adhesive force, and therefore the damage to the substrate due to a wet heat treatment can be reduced, leading to the suppression of oligomers. Examples of aromatic polycarboxylic acid in which carboxylic acid is substituted at an ortho position or an anhydride thereof include orthophthalic acid or an anhydride thereof, naphthalene 2,3-dicarboxylic acid or an anhydride thereof, naphthalene 1,2-dicarboxylic acid or an anhydride thereof, anthraquinone 2,3-dicarboxylic acid or an anhydride thereof, and 2,3-anthracene carboxylic acid or an anhydride thereof. These compounds may have a substituent at any carbon atom of an aromatic ring. Examples of the substituent include a chloro group, a bromo group, a methyl group, an ethyl group, an i-propyl group, a hydroxyl group, a methoxy group, an ethoxy group, a phenoxy group, a methylthio group, a phenylthio group, a cyano group, a nitro group, an amino group, a phthalimide group, a carboxyl group, a carbamoyl group, an N-ethylcarbamoyl group, a phenyl group, or a naphthyl group. The polyester polyol having a content rate of 70 to 100 mol% with respect to 100 mol% of all the polycarboxylic acid components is particularly preferable because the polyester polyol has a high effect of improving barrier properties and excellent solvent solubility essential for the coating material.

In the present invention, other polyvalent carboxylic acid components may be copolymerized as long as the effects of the invention are not impaired. Specifically, polybasic acids such as succinic acid, adipic acid, azelaic acid, sebacic acid, and dodecanedicarboxylic acid as aliphatic polyvalent carboxylic acid; maleic anhydride, maleic acid, and fumaric acid as unsaturated bond-containing polyvalent carboxylic acid; 1,3-cyclopentane dicarboxylic acid and 1,4-cyclohexanedicarboxylic acid as aliphatic polyvalent carboxylic acid; terephthalic acid, isophthalic acid, pyromellitic acid, trimellitic acid, 1,4-naphthalenedicarboxylic acid, 2,5-naphthalenedicarboxylic acid, 2,6-naphthalenedicarboxylic acid, naphthalic acid, biphenyldicarboxylic acid, diphenic acid and an anhydride thereof, 1,2-bis(phenoxy)ethane-p,p'-dicarboxylic acid, and anhydrides or ester forming derivatives of these dicarboxylic acids; and p-hydroxybenzoic acid, p-(2-hydroxyethoxy)benzoic acid and ester-forming derivatives of these dihydroxycarboxylic acids can be used alone or in a mixture of two or more thereof. Among them, succinic acid, 1,3-cyclopentanedicarboxylic acid, isophthalic acid, 2,6-naphthalenedicarboxylic acid, 1,8-naphthalic acid, and difenic acid are preferable from the viewpoint of organic solvent solubility and gas barrier properties.

### [Polyhydric alcohol component]

The polyhydric alcohol component of the polyester used in the present invention is not particularly limited as long as the polyhydric alcohol component can synthesize a polyester exhibiting performance for gas barrier compensation, but it is preferable to contain a polyhydric alcohol component containing at least one selected from the group consisting of ethylene glycol, propylene glycol, butylene glycol, neopentyl glycol, cyclohexanedimethanol, and 1,3-bishydroxyethylbenzene. Among them, ethylene glycol is most preferably used as a main component because it is estimated that as the number of carbon atoms between oxygen atoms is smaller, a molecular chain does not become excessively flexible and oxygen permeation is less likely to occur.

In the present invention, it is preferable to use the above-described polyhydric alcohol component, but other polyhydric alcohol components may be copolymerized as long as the effect of the present invention is not impaired. Specific examples of diols include 1,5-pentanediol, 3-methyl-1,5-pentanediol, 1,6-hexanediol, methylpentanediol, dimethylbutanediol, butylethylpropanediol, diethylene glycol, triethylene glycol, tetraethylene glycol, dipropylene glycol, and tripropylene glycol, and examples of trihydric or higher alcohols include glycerol, trimethylolpropane, trimethylolethane, tris(2-hydroxyethyl)isocyanurate, 1,2,4-butanetriol, pentaerythritol, and dipentaerythritol. In particular, among trihydric alcohols, a polyester in which glycerol and tris(2-hydroxyethyl)isocyanurate are used in combination is derived from a branched structure and has a moderately high crosslinking density, and thus has good organic solvent solubility and an excellent barrier function, and is particularly preferably used.

Examples of catalysts used in reactions for obtaining the polyester of the present invention include acid catalysts such as tin-based catalysts (such as monobutyl tin oxide and dibutyl tin oxide), titanium-based catalysts (such as tetra-isopropyl-titanate and tetra-butyl-titanate), and zirconia-based catalysts such as tetra-butyl-zirconate. It is preferable to use a combination of the above-described titanium-based catalyst, such as tetra-isopropyl-titanate or tetra-butyl-titanate, which has high activity for the ester reaction, and the above-described zirconia catalyst. The amount of the catalyst to be used is 1 to 1000 ppm, and more preferably 10 to 100 ppm, based on the total mass of a reaction raw material to be used. When the amount is less than 1 ppm, it is difficult to obtain the effect as the catalyst, and when the amount is more than 1000 ppm, an urethanization reaction may be disadvantageously inhibited when an isocyanate curing agent is used.

### (4) Isocyanate-based curing agent

In the present invention, when a polyester resin is used as the main agent of the coating agent constituting the coating layer, it is necessary to use an isocyanate-based curing agent as the curing agent to form an urethane resin. In this case, the coating layer becomes a crosslinking system, and therefore heat resistance, abrasion resistance, and rigidity are advantageously improved. Therefore, it is easy to use the present invention for boiling and retort packaging. Meanwhile, there are also problems that the liquid cannot be reused after mixing the curing agent, and a curing (aging) step is required after coating. As advantages, as a simple overcoat varnish, for example, coating production is easily managed without causing a risk of thickening the coating liquid, and the coating liquid can be diluted and reused. In addition, a curing step (so-called aging step) is unnecessary. At this time, the terminal of the polyester to be used can be a polyol, polycarboxylic acid, or a mixture thereof without any problem. Meanwhile, the resin of the coating layer is linear, and therefore heat resistance and abrasion resistance may not be sufficient, or it may be difficult to use the present invention for boiling or retort packaging.

When the curing agent is used for the coating layer, an isocyanate curing system is preferable from the viewpoint of the heat resistance of the film because of coating to the film. In this case, the resin component of the coating material needs to be a polyester polyol. Meanwhile, when an epoxy-based compound is used as the curing agent, polyester polycarboxylic acid is required. In these cases, the coating layer becomes a crosslinking system, and therefore heat resistance, abrasion resistance, and rigidity are advantageously improved. Therefore, it is easy to use the present invention for boiling and retort packaging. Meanwhile, there are also problems that the liquid cannot be reused after mixing the curing agent, and a curing (aging) step is required after coating.

When the polyester has a hydroxyl group, at least a part of the polyisocyanate compound used in the present invention reacts to form an urethane structure, and therefore the resin component is highly polarized, and the gas barrier function can be further enhanced by aggregating polymer chains. When the resin of the coating material is a linear resin, heat resistance and abrasion resistance can be imparted by crosslinking with a trivalent or higher polyisocyanate. The polyisocyanate compound used in the present invention may be any of a diisocyanate, a trivalent or higher polyisocyanate, a low molecular weight compound, and a polymer compound, but it is preferable that an aromatic ring or an aliphatic ring is contained in a part of a skeleton from the viewpoint of the gas barrier improving function. Examples of the isocyanate having an aromatic ring include toluene diisocyanate, diphenylmethane diisocyanate, xylylene diisocyanate, and naphthalene diisocyanate. Examples of the isocyanate having an aliphatic ring include hydrogenated xylylene diisocyanate, hydrogenated toluene diisocyanate, isophorone diisocyanate, norboron diisocyanate, trimers of these isocyanate compounds, and terminal isocyanate group-containing compounds obtained by reacting an excess amount of these isocyanate compounds with, for example, low molecular active hydrogen compounds such as ethylene glycol, propylene glycol, trimethylolpropane, glycerin, sorbitol, ethylenediamine, monoethanolamine, diethanolamine, and triethanolamine, or various polyester polyols, polyether polyols, and high molecular active hydrogen compounds such as polyamides.

A method for coating with the resin composition for coating layer is not particularly limited as long as a layer is formed by coating the film surface. For example, a usual coating method such as gravure coating, reverse roll coating, wire bar coating, or die coating can be adopted.

In forming the coating layer, heating and drying are preferably carried out after the resin composition for coating layer is applied. The drying temperature at that time is preferably 100 to 145 °C, more preferably 110 to 140 °C, even more preferably 110 to 130 °C. When the drying temperature is lower than 100°C, insufficient drying may occur in the coating layer. Meanwhile, when the drying temperature is higher than 145°C, the film is excessively heated, and therefore the film may be brittle or the film may shrink, resulting in deterioration in processability. In particular, the coating film is particularly preferable because a uniform film can be obtained when a solvent is first volatilized under a relatively low temperature condition of about 80°C to 110°C immediately after coating and then dried at 120°C or higher. In addition to drying, it is also more effective to perform an additional heat treatment in a low temperature range as much as possible in order to advance the formation of the coating layer.

### [Inorganic thin film layer]

The laminated film of the present invention may have an inorganic thin film layer on the surface of the coating layer. The inorganic thin film layer is a thin film including a metal or inorganic oxide. A material that forms the inorganic thin film layer is not particularly limited as far as the material is a material that can be made into a thin film. From the viewpoint of gas barrier performance, the material is preferably an inorganic oxide, such as silicon oxide (silica), aluminum oxide (alumina), or a mixture of silicon oxide and aluminum oxide. About the blend ratio between silicon oxide and aluminum oxide in this complex oxide, the metal proportion by mass of Al ranges preferably from 20 to 70% by mass. When the Al concentration is less than 20% by mass, the inorganic thin film layer may be lowered in water vapor barrier performance. In the meantime, when the concentration is more than 70% by mass, the inorganic thin film layer tends to be hardened, so that the film is broken in a secondary processing, such as printing or laminating, to be unfavorably lowered in gas barrier performance. When the Al concentration is 100% by mass, the water vapor barrier performance is good, but the inorganic thin film layer is made of a single material, and therefore the surface of the inorganic thin film layer tends to be smooth. The inorganic thin film layer has poor slipperiness, and therefore defects (wrinkles and acnes and the like) in processing are apt to occur. Silicon oxide referred to herein is a silicon oxide that may be of various types, such as SiO or SiO₂, or any mixture of such oxides, and aluminum oxide referred to herein is an aluminum oxide that may be of various types, such as AlO or Al₂O₃, or any mixture of such oxides.

The film thickness of the inorganic thin film layer is usually from 1 to 100 nm, preferably from 5 to 50 nm. When the film thickness of the inorganic thin film layer is less than 1 nm, the layer may not easily gain a satisfactory gas barrier performance. In the meantime, when the film thickness is set to more than 100 nm to be made excessively large, a gas-barrier-performance-improving effect corresponding to the thickness is not gained to give disadvantages conversely from the viewpoint of flexing resistance and production costs.

The method for forming the inorganic thin film layer is not particularly limited. A known vapor deposition method may be appropriately adopted, examples thereof including physical vapor deposition methods (PVD method) such as vacuum vapor deposition, sputtering and ion plating methods, and a chemical vapor deposition method (CVD method). The following will describe a typical method for forming the inorganic thin film layer, giving a silicon-oxide/aluminum-oxide based thin film as an example. In the case of adopting, for example, a vacuum vapor deposition method, it is preferred to use, as a vapor deposition raw material, for example, a mixture of SiO₂ and Al₂O₃, or a mixture of SiO₂ and Al. As the vapor deposition raw material, particles are usually used. At this time, the size of the individual particles is desirably a size that does not permit the pressure at the time of the vapor deposition to be changed. The particle size is preferably from 1 mm to 5 mm. For heating the particles, for example, the following manner may be adopted: resistance heating, high frequency induction heating, electron beam heating or laser heating. As a reactive gas, oxygen, nitrogen, hydrogen, argon, carbon dioxide gas, or water vapor may be introduced into the reaction system. Reactive vapor deposition using ozone addition, ion assist or some other means may also be adopted. Furthermore, any change may be applied also to film-forming conditions, for example, bias is applied to a body which vapor deposition is to be applied (a laminated film to be supplied for vapor deposition), or this body is heated or cooled. Also in the case of adopting a sputtering or CVD method, change may be made about, for example, such a vapor deposition raw material, a reactive gas, bias to a body which vapor deposition is to be applied, and/or heating/cooling.

### [Protective layer]

In the present invention, when gas barrier performance is further required or processing such as printing is required, a protective layer can also be provided on the inorganic thin film layer. The inorganic thin film layer is not completely a dense film, and has dotted microscopic deficient moieties. By applying, onto the inorganic thin film layer a specific resin composition for protective layer, that will be described later to form the protective layer, a resin in the resin composition for protective layer invades the deficient moieties of the inorganic thin film layer to produce an advantageous effect of stabilizing the gas barrier performance of the laminated layer. Additionally, by using a material having gas barrier performance in the protective layer itself, the laminated film is also largely improved in gas barrier performance. However, it should be noted that the provision of the protective layer causes a cost increase due to an increase in the number of steps, and an environment load depending on a material to be used. It should also be noted that the protective layer changes physical property values such as surface roughness.

In the present invention, the adhesion amount of the protective layer is set into a range preferably from 0.10 to 0.50 g/m². This case allows to control the protective layer evenly in applying for this layer. As a result, the layer becomes a film little in coat unevenness and defect quantity. Moreover, the protective layer itself is improved in cohesive force to strengthen adhesion between the inorganic thin film layer and the protective layer. When the adhesion amount of the protective layer is more than 0.50 g/m², the laminated film is improved in gas barrier performance but the inside of the protective layer is insufficient in cohesive force and is also lowered in evenness so that the external appearance of the coat undergoes unevenness or defects. Thus, the laminated film may not sufficiently exhibit gas barrier performance nor adhesion. In the meantime, when the film thickness of the protective layer is less than 0.10 g/m², the laminated film may not unfavorably gain a sufficient gas barrier performance nor interlayer adhesion.

Examples of the resin composition used for the protective layer formed on the surface of the inorganic thin film layer of the laminated film of the present invention include a resin composition obtained by adding a curing agent such as an epoxy-based curing agent, an isocyanate-based curing agent, or a melamine-based curing agent to a resin such as a vinyl alcohol-based resin, an urethane-based resin, a polyester-based resin, an acryl-based resin, a titanium-based resin, an isocyanate-based resin, an imine-based resin, or a polybutadiene-based resin.

A method for coating with the resin composition for protective layer is not particularly limited as long as a layer is formed by coating the film surface. For example, a usual coating method such as gravure coating, reverse roll coating, wire bar coating, or die coating can be adopted.

### [Laminated film]

The laminated film of the present invention exhibits the following film properties. The following physical properties are measured and evaluated by methods to be described later in Examples.

The thickness of the entire laminated film of the **present invention is preferably 9 µm or more and 200 m or less, more preferably 10 µm or more and 150 um or less, still more preferably 12 µm or more and 100 µm or less, and particularly preferably 15 µm or more and 80 µm or less.**

The thickness of the entire substrate layer with respect to the thickness of the entire film is preferably 50% or more and 99% or less, more preferably 60% or more and 97% or less, particularly preferably 70% or more and 95% or less, and most preferably 80% or more and 92% or less.

In the laminated film of the present invention, a ratio (P2/P1) of a peak intensity (P1) having an absorption maximum in a domain of 1720±10 cm⁻¹ to a peak intensity (P2) having an absorption maximum in a domain of 1070±10 cm⁻¹ in the total reflection infrared absorption spectrum of the coating layer is preferably within a range of 0.1 or more and 30.0 or less. The ratio (P1/P2) is preferably within a range of 0.1 to 20.0, and more preferably within a range of 0.2 to 10.0. The peak at 1720±10 cm⁻¹ is a peak derived from a C=O structure derived from an aromatic or araliphatic ester skeleton, and is an index indicating the amount of a polyester skeleton. The peak at 1070±10 cm⁻¹ is a peak derived from C-OH, and is an index indicating the amount of hydroxyl groups derived from polyester in the coating layer. (P2/P1) represents the ratio of hydroxyl groups in the polyester skeleton. When this ratio is within the above range, the film is highly polarized without impairing the toughness of the film, and when the inorganic thin film layer is laminated, the adhesion force between the coating layer and the inorganic thin film layer is increased, and as a result, the gas barrier performance is maximized. When (P2/P1) is less than 0.1, the amount of hydroxyl groups in the coating layer is small, the film formation of the inorganic thin film layer becomes sparse, and therefore the gas barrier properties may be difficult to obtain. Meanwhile, when (P2/P1) exceeds 30.0, the bonding force with the inorganic thin film layer is enhanced, but crosslinking in the coating layer does not proceed, so that film formability may be deteriorated to make the film brittle. In order to set the value of (P1/P2) of the coating layer to the predetermined numerical ranges, it is necessary to set the predetermined adhesion amount of the above-described materials, set the blending ratios of the materials to the above-described appropriate ranges, and combine the predetermined adhesion amount and the blending ratios with drying and heat treatment conditions to be described later.

The laminated film of the present invention has a heating elongation rate at 100°C of 3% or less in both MD and TD directions. As a result, the substrate hardly stretches due to heat received from an evaporation source and vapor-deposited particles during the lamination of the inorganic thin film layer, and gas barrier performance and quality can be further improved. The heating elongation rate in the MD direction and the TD direction at 100°C is preferably 2.8% or less, more preferably 2.5% or less, and the lower limit thereof is preferably 0%. When the heating elongation rate in the MD direction at 100°C exceeds 3%, the laminated film may be deformed by heat received from an evaporation source or vapor-deposited particles during the lamination of the inorganic thin film layer, so that the gas barrier property may be deteriorated or the quality may be deteriorated.

The heating elongation rate at 130°C is preferably 10% or less in both the MD direction and the TD direction. The heating elongation rate in the MD direction and the TD direction at 130°C is preferably 8% or less, more preferably 7% or less, still more preferably 6.5% or less, and the lower limit thereof is preferably 0%.

In the present invention, the heating elongation rate is a value measured by a TMA method, and more specifically, according to the method described in Examples.

The total of the maximum peak height (Rp) and maximum valley depth (Rv) of the coating layer side-surface of the laminated film of the present invention measured with a scanning probe microscope (AFM) is suitably 0.1 nm or more and 30.0 nm or less. The maximum peak height (Rp) and the maximum valley depth (Rv) are obtained in accordance with the definition described in JIS-B0601 (1994) after measurement is performed in a range in which measurement **lengths in X and Y directions are both 2 µm in a dynamic** mode using the scanning probe microscope (AFM), and an obtained image is corrected (slope, line fit, noise line removal).

The maximum peak height (Rp) and the maximum valley **depth (Rv) in the 2 µm square range by the AFM are indices** indicating unevenness of the resin itself other than relatively large peaks and valleys formed by the antiblocking agent and the lubricant, and when the inorganic thin film layer is laminated on the surface of the coating layer, the formation failure of the inorganic thin film layer due to unevenness or cracking may occur. When the total of the maximum peak height (Rp) and maximum valley depth (Rv) is more than 30.0 nm, the surface unevenness is large, voids occur during the formation of the inorganic thin film, and therefore barrier properties or the like become poor. The total of the maximum peak height (Rp) and maximum valley depth (Rv) of the coating layer-side surface is more preferably 20.0 nm or less, still more preferably 10.0 nm or less, and most preferably 7.0 nm or less.

When the inorganic thin film layer is laminated on the laminated film of the present invention, the oxygen permeation rate under conditions of 23°C×65% RH is preferably 15 cc/m²/d/atm or less. The oxygen permeation rate is more preferably 10 cc/m²/d/atm or less, and still more preferably 8 cc/m²/d/atm or less. A preferable lower limit of the oxygen permeation rate is 0.1 cc/m²/d/atm or more. The water vapor permeation rate under conditions of 40°C×90% RH is preferably 3.0 g/m²/d or less. The water vapor permeation rate is more preferably 2.5 g/m²/d or less, and more preferably 2.0 g/m²/d or less. A preferable lower limit of the water vapor permeation rate is 0.1 g/m²/d or more.

### [Laminated body]

When the laminated film of the present invention is used as a packaging material, it is preferable to form a laminated body on which a heat-sealable resin layer called a sealant is formed. The heat-sealable resin layer is usually provided on the coating layer or inorganic thin film layer side, but may be provided on the outer side of the substrate film layer (the surface opposite to the inorganic thin film forming surface). The heat-sealable resin layer is usually formed by an extrusion lamination method or a dry lamination method. As a thermoplastic polymer that forms the heat-sealable resin layer, any one may be used as long as the sealant adhesiveness can be sufficiently exerted. Polyethylene resins such as olefin-based HDPE, LDPE and LLDPE, a polypropylene resin, an ethylene-vinyl acetate copolymer, an ethylene-α-olefin random copolymer, and an ionomer resin can be used. Among them, LLDPE or a polypropylene resin having high versatility is particularly preferable from the viewpoint of durability, seal strength, price, and monomaterialization. The thickness of the sealant layer is **preferably 20 to 100 µm, more preferably 30 to 90 µm, and still more preferably 40 to 80 µm. When the thickness is less than 20 µm, sufficient sealing strength cannot be** obtained, and the laminated body may have no tough feeling, resulting in difficult handling. Meanwhile, when the **thickness is more than 100 µm, the laminated body has high** tough feeling, has deteriorated handleability as a bag, and may be expensive.

### [Adhesive Layer]

For the adhesive layer used in the present invention, a general-purpose adhesive for lamination can be used. For example, it is possible to used solvent (free) type, aqueous type, and hot melt type adhesives containing poly(ester) urethane-based materials, polyester-based materials, polyamide-based materials, epoxy-based materials, poly (meth)acrylic-based materials, polyethyleneimine-based materials, ethylene-(meth)acrylic acid-based materials, polyvinyl acetate-based materials, (modified) polyolefin-based materials, polybutadiene-based materials, wax-based materials, casein-based materials and the like as a main component. Among these, urethane-based or polyester-based materials are preferable in consideration of heat resistance and flexibility that can follow the heating elongation of each base material. As a method for laminating the adhesive layer, for example, the adhesive layer can be coated by a direct gravure coating method, a reverse gravure coating method, a kiss coating method, a die coating method, a roll coating method, a dip coating method, a knife coating method, a spray coating method, a fountain coating method, and other methods. The coated amount after drying is preferably 1 to 8 g/m² in order to exert sufficient adhesive properties. The coated amount is more preferably 2 to 7 g/m², still more preferably 3 to 6 g/m². When the coated amount is less than 1 g/m², it is difficult to paste the entire surface and the adhesive strength decreases. When the coated amount is more than 8 g/m², it takes time to completely cure the film, unreacted substances are likely to remain, and the adhesive strength decreases.

### [Printed Layers]

Furthermore, in the laminated film of the present invention, at least one or more printed layers, and one or more different plastic films and/or sheets of paper may be laminated between the substrate film layer and the heat-sealable resin layer, or the outside thereof.

As a printing ink for forming the printed layer, an aqueous and solvent-based resin-containing printing ink can be preferably used. Examples of the resin used in the printing ink include an acrylic resin, a urethane-based resin, a polyester-based resin, a vinyl chloride-based resin, a vinyl acetate copolymer resin, and a mixture thereof. The printing ink may contain known additives such as an anti-static agent, a light blocking agent, an ultraviolet absorber, a plasticizer, a lubricant, a filler, a coloring agent, a stabilizer, a lubricant, a defoaming agent, a crosslinking agent, an anti-blocking agent, and an oxidation inhibitor. A printing method for providing the printing layer is not particularly limited, and known printing methods such as an offset printing method, a gravure printing method, and a screen printing method can be used. In order to dry the solvent after printing, known drying methods such as hot air drying, hot roll drying, and infrared drying can be used.

### EXAMPLES

Next, the present invention will be described in more detail by way of Examples, but the present invention is not limited to the following examples. The evaluation of films was performed by the following measurement methods.

### [Measuring method]

### (1) Method for measuring total reflection infrared absorption spectrum of laminated film

In each of Examples and Comparative Examples, the total reflection infrared absorption spectrum of the coating layer surface of each single laminated film obtained at the stage of laminating a coating layer on a substrate film was measured by total reflection absorption infrared spectroscopy. A peak intensity (P1) having an absorption maximum in a domain of 1720±10 cm⁻¹ and a peak intensity (P2) having an absorption maximum in a domain of 1070±10 cm⁻¹ were determined, and the intensity ratio (P2/P1) thereof was calculated. The intensity of each peak was calculated from a peak height obtained by vertically connecting a base line with zero absorbance and the top of each peak.

### (2) Maximum peak height (Rp) and maximum valley depth (Rv) (nm)

In each of Examples and Comparative Examples, the maximum peak height (Rp) and maximum valley depth (Rv) of the coating layer-side surface of the obtained laminated film were measured using a scanning probe microscope ("SPM-9700" manufactured by Shimadzu Corporation). Measurement was performed in a phase mode in a range in which both **measurement lengths in X and Y directions were 2 µm, and** the obtained image was corrected (tilt, line fitting, noise line removal), and the maximum peak height (Rp) and the maximum valley depth (Rv) were then obtained according to the definition described in JIS-B0601 (1994).

### (3) Amount of adhesion of coating layer

In each of Examples and Comparative Examples, each laminated film obtained at the stage of laminating a coating layer on a substrate film was used as a sample, and a 100 mm×100 mm test piece was cut out from this sample. The coating layer was wiped with acetone, and an amount of adhesion was calculated from the mass change of the film before and after wiping.

### (4) Heating elongation rate (%)

In each of Examples and Comparative Examples, the heating elongation rate was determined by temperature modulation TMA measurement using a thermomechanical analyzer ("TMA-60" manufactured by Shimadzu Corporation).

Regarding the heating elongation rate in the MD direction, a strip was cut out from each of the laminated films of Examples and Comparative Examples so as to have a width of 30 mm in the MD direction and a width of 4 mm in the TD direction to prepare a sample. As measurement conditions, a distance between chucks was 10 mm, a measurement temperature range was 30°C to 150°C, a temperature raising rate was 20°C/min, and a tensile load applied to a sample piece was 0.39 N. The heating elongation rate was determined from the distance (mm) between chucks when the temperature in the furnace reached 100°C and the distance (mm) between chucks when the temperature in the furnace reached 130°C.

Regarding the heating elongation rate in the TD direction, a strip was cut out from each of the laminated films of Examples and Comparative Examples so as to have a width of 30 mm in the TD direction and a width of 4 mm in the MD direction to prepare a sample. As measurement conditions, a distance between chucks was 10 mm, a measurement temperature range was 30°C to 150°C, a temperature raising rate was 20°C/min, and a tensile load applied to a sample piece was 0.39 N. The heating elongation rate was determined from the distance (mm) between chucks when the temperature in the furnace reached 100°C and the distance (mm) between chucks when the temperature in the furnace reached 130°C.

The heating elongation rate at the time of reaching 100°C (S100) and the heating elongation rate at the time of reaching 130°C (S130) were each determined by the following formula. (S100) = (distance between chucks when heated to 100°C - distance between chucks before temperature rise) /distance between chucks before temperature rise × 100 (S130) = (distance between chucks when heated to 130°C - distance between chucks before temperature rise) /distance between chucks before temperature rise × 100

### (5) Composition and film thickness of inorganic thin film layer

The film thickness and composition of the laminated film (after lamination of a thin film) obtained in each of Examples and Comparative Examples were measured by a calibration curve prepared in advance using an X-ray fluorescence analyzer ("ZSX 100e" manufactured by Rigaku Corporation). The conditions of an x-ray excitation tube were 50 kV and 70 mA.

### (6) Method for evaluating oxygen permeation rate

The oxygen permeation rate of the laminated films (after the lamination of the thin film) obtained in each of Examples and Comparative Examples was measured in an atmosphere having a temperature of 23°C and a humidity of 65% RH using an oxygen permeation rate analyzer ("OX-TRAN (registered trademark) 1/50" manufactured by MOCON) according to the JIS-K7126 B method. The oxygen permeation rate was measured in a direction in which oxygen permeated from a substrate layer side.

### (7) Method for evaluating water vapor permeation rate

The water vapor permeation rate of the laminated films (after the lamination of the thin film) obtained in each of Examples and Comparative Examples was measured in an atmosphere at a temperature of 40°C and a humidity of 90% RH using a water vapor permeation rate measuring apparatus ("PERMATRAN-W 3/33MG" manufactured by MOCON) according to the JIS-K7129 B method. The water vapor permeation rate was measured in a direction in which water vapor permeated from a substrate layer side.

### (8) Appearance evaluation method

In each of Examples and Comparative Examples, the appearance of the coating layer-side surface was visually evaluated after the coating layer was laminated.
∘: Good without occurrence of defects
×: Any drawback of wrinkles, coating uniformity, and cissing occurs.

### [Preparation of substrate film]

Details of the polypropylene-based resin raw materials used in the preparation of the following polyolefin substrate film, film formation conditions, and raw material blending ratios are shown in Tables 1 to 4.

**[Table 1]**

| Polypropylene-based resin | PP-1 | PP-2 | PP-3 |
|---|---|---|---|
| Raw material monomer | Propylene | Propylene | Propylene |
| Resin stereoregularity (meso-pentad fraction (%)) | 98.7 | 98.9 | 98.4 |
| MFR (g/10 min, 230°C, 2.16 kgf) | 7.6 | 1.9 | 3.0 |
| Molecular weight (Mn) | 67,500 | 80,000 | 79,400 |
| Molecular weight (Mw) | 270,000 | 360,000 | 312,000 |
| Molecular weight distribution (Mw/Mn) | 4.0 | 4.5 | 3.9 |
| DSC melting peak temperature (°C) | 168.0 | 163.3 | 163.9 |
| DSC melting peak area (J/g) | 105.2 | 94.3 | 98.6 |

**[Table 2]**

| Masterbatch | A |
|---|---|
| Product name of masterbatch | FTX0627G |
| Antiblocking agent in masterbatch | Silica particles |
| Average particle size of antiblocking **agent (µm)** | 2.7 |
| Content of antiblocking agent in masterbatch (ppm by weight) | 50000 |
| MFR of polypropylene resin in masterbatch (g/10 min, 230°C, 2.16 kgf) | 3.0 |

**[Table 3]**

| Film formation condition | a | b |
|---|---|---|
| Molten resin temperature (°C) | 250 | 250 |
| Cooling roll temperature (°C) | 30 | 30 |
| Stretching ratio in machine direction (times) | 4.5 | 4.5 |
| Stretching temperature in machine direction (°C) | 135 | 125 |
| Stretching ratio in transverse direction (times) | 8.2 | 8.2 |
| Stretching preheating temperature in transverse direction (°C) | 173 | 168 |
| Stretching temperature in transverse direction (°C) | 164 | 155 |
| Heat setting temperature (°C) | 171 | 165 |
| Relaxation rate in transverse direction (%) | 6.7 | 6.7 |

**[Table 4]**

| | | | | OPP-1 | OPP-2 |
|---|---|---|---|---|---|
| Substrate layer (A) | Raw material | PP-1 | % by weight | 100.00 | 0.00 |
| | | PP-2 | % by weight | 0.00 | 40.00 |
| | | PP-3 | % by weight | 0.00 | 60.00 |
| | Thickness | | **µm** | 18 | 18 |
| Surface layer (B) | Raw material | PP-1 | % by weight | 96.4 | 0.0 |
| | | PP-2 | % by weight | 0.0 | 0.0 |
| | | PP-3 | % by weight | 0.0 | 96.4 |
| | | Antiblocking agent-containing masterbatch | % by weight | 3.6 | 3.6 |
| | | Masterbatch type | | A | A |
| | Thickness | | **µm** | 1.0 | 1.0 |
| | Surface treatment | | | Corona treatment | Corona treatment |
| Surface layer (C) | Raw material | PP-1 | % by weight | 94.0 | 0.0 |
| | | PP-2 | % by weight | 0.0 | 0.0 |
| | | PP-3 | % by weight | 0.0 | 94.0 |
| | | Antiblocking agent-containing masterbatch | % by weight | 6.0 | 6.0 |
| | | Masterbatch type | | A | A |
| | Thickness | | **µm** | 1.0 | 1.0 |
| | Surface treatment | | | No treatment | No treatment |
| Blending amount in film | | PP-1 | % by weight | 99.52 | 0.00 |
| | | PP-2 | % by weight | 0.00 | 36.00 |
| | | PP-3 | % by weight | 0.00 | 63.52 |
| | | Antiblocking agent-containing masterbatch | % by weight | 0.48 | 0.48 |
| | | Content of antiblocking agent | ppm | 240 | 240 |
| Film formation condition (see Table 3) | | | | a | b |

### (OPP-1)

For a substrate layer (A), a polypropylene homopolymer PP-1 shown in Table 1 was used.

For a surface layer (B), there was used a blend of 96.4% by weight of a polypropylene homopolymer PP-1 shown in Table 1, and 3.6% by weight of masterbatch A shown in Table 2.

For a surface layer (C), there was used a blend of 94.0% by weight of a polypropylene homopolymer PP-1 shown in Table 1 and 6.0% by weight of masterbatch A shown in Table 2.

Using a 45 mm extruder for the substrate layer (A), a 25 mm extruder for the surface layer (B), and a 20 mm extruder for the surface layer (C), raw material resins were melted at 250°C, co-extruded from a T die into a sheet, cooled and solidified so that the surface layer (B) was in contact with a cooling roll at 30°C, and then stretched 4.5 times in a machine direction (MD) at 135°C. Then, in a state where both ends in a film transverse direction (TD) were pinched by clips in a tenter, the film was preheated at 173°C, then stretched 8.2 times in the transverse direction (TD) at 164°C, and subjected to heat setting at 171°C while being relaxed by 6.7% in the transverse direction (TD). The film formation condition at this time was defined as a film formation condition a.

Thus, a biaxially oriented polypropylene-based film having a structure of surface layer (B)/substrate layer (A)/surface layer (C) was obtained.

The surface of the surface layer (B) of the biaxially oriented polypropylene-based film was subjected to a corona treatment under a condition of an applied current value: 0.75 A using a corona treatment machine manufactured by Softal Corona and Plasma GmbH, and then wound up with a **winder. The thickness of the obtained film was 20 um (the** thicknesses of the surface layer (B), substrate layer (A), and surface layer (C) were respectively 1.0 **µm,** 18.0 **um, and 1.0 µm).**

### (OPP-2)

For a substrate layer (A), there was used a blend of 40.0% by weight of a polypropylene homopolymer PP-2 shown in Table 1 and 60.0% by weight of a polypropylene homopolymer PP-3 shown in Table 1.

For a surface layer (B), there was used a blend of 96.4% by weight of a polypropylene homopolymer PP-3 shown in Table 1 and 3.6% by weight of masterbatch A shown in Table 2.

For a surface layer (C), there was used a blend of 94.0% by weight of a polypropylene homopolymer PP-3 shown in Table 1 and 6.0% by weight of masterbatch A shown in Table 2.

Using a 45 mm extruder for the substrate layer (A), a 25 mm extruder for the surface layer (B), and a 20 mm extruder for the surface layer (C), raw material resins were melted at 250°C, co-extruded from a T die into a sheet, cooled and solidified so that the surface layer (B) was in contact with a cooling roll at 30°C, and then stretched 4.5 times in a machine direction (MD) at 125°C. Then, in a state where both ends in a film transverse direction (TD) were pinched by clips in a tenter, the film was preheated at 168°C, then stretched 8.2 times in the transverse direction (TD) at 155°C, and subjected to heat setting at 165°C while being relaxed by 6.7% in the transverse direction (TD). The film formation condition at this time was defined as a film formation condition b.

Thus, a biaxially oriented polypropylene-based film having a structure of surface layer (B)/substrate layer (A)/surface layer (C) was obtained.

The surface of the surface layer (B) of the biaxially oriented polypropylene-based film was subjected to a corona treatment under a condition of an applied current value: 0.75 A using a corona treatment machine manufactured by Softal Corona and Plasma GmbH, and then wound up with a **winder. The thickness of the obtained film was 20 µm (the** thicknesses of the surface layer (B), substrate layer (A), and surface layer (C) were respectively 1.0 **µm,** 18.0 **um, and 1.0 µm).**

### [Preparation of coating layer]

Hereinafter, a method for preparing a coating layer used in each of Examples and Comparative Examples will be described.

### [Polyester resin (A)]

As a polyester component, a polyester polyol ("DF-COAT GEC-004C" manufactured by DIC Corporation; solid content 30%) was used.

### [Polyisocyanate crosslinking agent (B)]

As a polyisocyanate component, a trimethylolpropane adduct of meta-xylylene diisocyanate ("TAKENATE D-110N" manufactured by Mitsui Chemicals, Inc.; solid content 75%) was used.

### [Silane coupling agent (C)]

As the silane coupling agent, N-2-(aminoethyl)-3-aminopropyltrimethoxysilane ("KBM-603" manufactured by Shin-Etsu Chemical Co., Ltd.) was used.

### [Urethane resin (D)]

As the urethane resin, a polyester urethane resin dispersion ("Hydran (registered trademark) AP-201" manufactured by DIC Corporation; solid content 23%) was used.

### [Urethane resin (E)]

As the urethane resin, a polyester urethane resin dispersion ("TAKELAC (registered trademark) WPB531" manufactured by Mitsui Chemicals, Inc.; solid content 30%) was used.

### [Coating liquid 1]

A solution (15% by mass) obtained by dissolving the silane coupling agent (C) in acetone and the isocyanate (B) were mixed at the following ratio, and the mixture was stirred for 10 minutes using a magnetic stirrer. The resulting prepared liquid was diluted with methyl ethyl ketone and 1-methoxy-2-propanol (hereinafter referred to as PGM), and the polyester resin (A) was further added to obtain a desired coating liquid 1. The mixing ratio is shown below.

| | |
|---|---|
| Polyester resin (A) | 10.62% by mass |
| Isocyanate (B) | 4.07% by mass |
| Silane coupling agent (C) * acetone diluted solution | 1.73% by mass |
| Methyl ethyl ketone | 69.55% by mass |
| PGM | 14.03% by mass |

### [Coating liquid 2]

The following coating agents were mixed to prepare a coating liquid 2.

| | |
|---|---|
| Water | 43.91% by mass |
| Isopropanol | 30.00% by mass |
| Urethane resin (D) | 26.09% by mass |

### [Coating liquid 3]

The following coating agents were mixed to prepare a coating liquid 3.

| | |
|---|---|
| Water | 46.00% by mass |
| Isopropanol | 30.00% by mass |
| Urethane resin (E) | 24.00% by mass |

### [Preparation of laminated film]

### (Examples 1 and 2)

OPP-1 was used as a substrate film, and a coating liquid 1 was used as a coating layer. The coating liquid 1 was applied onto the corona-treated surface of the substrate film by a gravure roll coating method, and dried in a dry oven at 130°C for 10 seconds. The amount of adhesion of the coating layer at this time was 0.40 g/m². Thereafter, a post-heat treatment was performed at 40°C for 2 days to obtain a desired laminated film.

### (Example 3)

A desired laminated film was obtained under the same conditions as in Example 1 except that a coating liquid 2 was used as a coating layer.

### (Example 4)

A desired laminated film was obtained under the same conditions as in Example 1 except that the amount of adhesion of a coating layer was changed to 0.25 g/m².

### (Example 5)

A desired laminated film was obtained under the same conditions as in Example 1 except that a drying temperature was changed to 110°C.

### (Example 6)

A desired laminated film was obtained under the same conditions as in Example 1 except that a drying temperature was changed to 150°C.

### (Comparative example 1)

The same substrate film as in Example 1 was used, and a coating layer was not laminated.

### (Comparative Example 2)

A desired laminated film was obtained under the same conditions as in Example 1 except that a coating liquid 3 was used as a coating layer.

### (Comparative example 3)

A desired laminated film was obtained under the same conditions as in Example 1 except that OPP-2 was used as a substrate film.

### [Formation of inorganic thin film layer]

Hereinafter, a method for preparing an inorganic thin film layer used in each of Examples and Comparative Examples will be described.

### (M-1; Example 1 and Comparative example 1)

As an inorganic thin film layer M-1, a composite oxide layer composed of silicon dioxide and aluminum oxide was formed on the coating layer by an electron beam vapor-deposition method. Particulate SiO₂ (purity: 99.9 %) and Al₂O₃ (purity: 99.9%) having a size of about 3 mm to 5 mm were used as a vapor-deposition source. The film thickness of the inorganic thin film layer (SiO₂/Al₂O₃ composite oxide layer) in the film (inorganic thin film layer/coating layer-containing film) obtained as described above was 13 nm. The composition of the composite oxide layer was SiO₂/Al₂O₃ (mass ratio)=60/40.

### (M-2; Examples 2 to 6 and Comparative examples 2 to 3)

As an inorganic thin film layer M-2, metal aluminum was vapor-deposited on the coating layer. After the pressure was reduced to 10⁻³ Pa or less using a small vacuum vapor-deposition apparatus (VWR-400/ERH, manufactured by ULVAC KIKO, Inc.), an aluminum foil having a purity of 99.9% was set in a vapor-deposition source CF-305W manufactured by Nilaco Corporation from the lower portion of the substrate. The metal aluminum was evaporated by heating, to form a metal aluminum film having a thickness of 40 nm.

For the laminated film prepared as described above, the results of performing various evaluations on the obtained laminated films are shown in Table 5.

**[Table 5A]**

| | | | Unit | Example 1 | Example 2 | Example 3 | Example 4 | Example 5 | Example 6 |
|---|---|---|---|---|---|---|---|---|---|
| Substrate film | Type | | - | OPP-1 | OPP-1 | OPP-1 | OPP-1 | OPP-1 | OPP-1 |
| Coating layer | Coating liquid | None | - | | | | | | |
| | | 1 | - | ● | ● | | ● | ● | ● |
| | | 2 | - | | | ● | | | |
| | | 3 | - | | | | | | |
| | Coating condition | Drying temperature | °C | 130 | 130 | 130 | 130 | 110 | 150 |
| | | Drying time | seconds | 10 | 10 | 10 | 10 | 10 | 10 |
| | | Amount of adhesion | g/m² | 0.40 | 0.40 | 0.40 | 0.25 | 0.40 | 0.40 |
| | Appearance | Visual evaluation | - | ○ | ○ | ○ | ○ | ○ | ○ |
| | Heating elongation rate 100°C | MD direction | % | 1.7 | 1.7 | 1.8 | 1.9 | 2.3 | 1.7 |
| | | TD direction | % | 1.4 | 1.4 | 1.0 | 1.3 | 1.0 | 0.9 |
| | Heating elongation rate 130°C | MD direction | % | 4.9 | 4 . 9 | 4.5 | 5.4 | 6.4 | 4.2 |
| | | TD direction | % | 3.9 | 3.9 | 3.1 | 3.5 | 3.0 | 2.6 |
| | Surface roughness | Rp | nm | 1.6 | 1.6 | 4.2 | 1.6 | 0.9 | 2.8 |
| | | Rv | nm | 1.4 | 1.4 | 2.7 | 1.6 | 0.9 | 2.3 |
| | | (Rp + Rv) | nm | 3.0 | 3.0 | 6.8 | 3.2 | 1.7 | 5.1 |
| | IR peak | 1720 ± 10 cm-1 (P1) | - | 0.02 | 0.02 | 0.05 | 0.01 | 0.02 | 0.03 |
| | | 1070 ± 10 cm-1 (P2) | - | 0.06 | 0.06 | 0.11 | 0.03 | 0.06 | 0.06 |
| | | (P2/P1) | - | 2.3 | 2.3 | 2.2 | 5.1 | 2.5 | 2.4 |
| Inorganic thin film layer | Type | | - | M-1 | M-2 | M-2 | M-2 | M-2 | M-2 |
| | Thickness | | nm | 20 | 40 | 40 | 40 | 40 | 40 |
| | Oxygen permeation rate | | cc/m²▪day▪ atm | 1.7 | 4.5 | 5.3 | 4 . 9 | 4.6 | 6.2 |
| | Water vapor permeation rate | | g/m²▪day | 1.0 | 0.3 | 0.8 | 0.4 | 0.4 | 0.3 |

**[Table 5B]**

| | | | Unit | Comparative Example 1 | Comparative Example 2 | Comparative Example 3 |
|---|---|---|---|---|---|---|
| Substrate film | Type | | - | OPP-1 | OPP-1 | OPP-2 |
| Coating layer | Coating liquid | None | - | ● | | |
| | | 1 | - | | | ● |
| | | 2 | - | | | |
| | | 3 | - | | ● | |
| | Coating condition | Drying temperature | °C | - | 130 | 130 |
| | | Drying time | seconds | - | 10 | 10 |
| | | Amount of adhesion | g/m² | - | 0.40 | 0.40 |
| | Appearance | Visual evaluation | - | ○ | ○ | × |
| | Heating elongation rate 100°C | MD direction | % | 1.8 | 1.5 | 3.4 |
| | | TD direction | % | 1.4 | 1.3 | 1.5 |
| | Heating elongation rate 130°C | MD direction | % | 4.5 | 4.1 | 10.7 |
| | | TD direction | % | 3.4 | 4.4 | 4.6 |
| | Surface roughness | Rp | nm | 21.3 | 20.0 | 1.5 |
| | | Rv | nm | 22.4 | 16.6 | 1.4 |
| | | (Rp + Rv) | nm | 43.7 | 36.7 | 2.9 |
| | IR peak | 1720 ± 10 cm-1 (P1) | - | 0.00 | 0.01 | 0.02 |
| | | 1070 ± 10 cm-1 (P2) | - | 0.00 | 0.06 | 0.05 |
| | | (P2/P1) | - | -1.4 | 4.1 | 3.0 |
| Inorganic thin film layer | Type | | - | M-1 | M-2 | M-2 |
| | Thickness | | nm | 20 | 40 | 40 |
| | Oxygen permeation rate | | cc/m²▪day▪ atm | 99.6 | 15.6 | 10.2 |
| | Water vapor permeation rate | | g/m²▪day | 3.7 | 0.6 | 0.8 |

### INDUSTRIAL APPLICABILITY

According to the present invention, it is possible to provide a laminated film which can form a laminated structure mainly composed of a polypropylene film and composed of substantially a single resin species having a low environmental load, and has gas barrier properties required for a packaging material when an inorganic thin film layer is laminated.

## Claims

1. A laminated film for forming an inorganic thin film layer, comprising: a substrate layer mainly composed of a polypropylene-based resin; and a coating layer laminated on at least one surface of the substrate layer,
wherein the laminated film satisfies the following requirements (I) to (III):
(I) the laminated film has a heating elongation rate at 130°C of 10% or less in both MD and TD directions;
(II) a total of a maximum peak height (Rp) and maximum valley depth (Rv) of the coating layer-side surface measured with a scanning probe microscope is 30.0 nm or less; and
(III) an amount of adhesion of the coating layer is 0.10 g/m² or more and 0.50 g/m² or less.

2. The laminated film for forming an inorganic thin film layer according to claim 1, wherein the laminated film has a heating elongation rate at 100°C of 3% or less in both MD and TD directions.

3. The laminated film for forming an inorganic thin film layer according to claim 1 or 2, wherein in a total reflection infrared absorption spectrum measured from a coating layer side of the laminated film, a ratio (P2/P1) of a peak intensity (P1) having an absorption maximum in a domain of 1720±10 cm⁻¹ to a peak intensity (P2) having an absorption maximum in a domain of 1070±10 cm⁻¹ is within a range of 0.1 or more and 30.0 or less.

4. A laminated film comprising an inorganic thin film layer laminated on the coating layer of the laminated film according to any one of claims 1 to 3.

5. The laminated film according to claim 4, wherein the inorganic thin film layer contains Al and/or Si.
